Europäisches Patentamt

European Patent Office

Office européen des brevets

(19)

(11) Numéro de publication: **0 360 662**
**A1**

(12)

# DEMANDE DE BREVET EUROPEEN

(21) Numéro de dépôt: 89402505.5

(22) Date de dépôt: 13.09.89

(51) Int. Cl.⁵: **C 04 B 35/00**
**H 01 L 39/12, H 01 L 39/24**

(30) Priorité: 21.09.88 FR 8812323

(43) Date de publication de la demande:
28.03.90 Bulletin 90/13

(84) Etats contractants désignés:
AT BE CH DE ES FR GB GR IT LI LU NL SE

(71) Demandeur: **RHONE-POULENC CHIMIE**
**25, quai Paul Doumer**
**F-92408 Courbevoie Cédex (FR)**

(72) Inventeur: **Teichner, Stanislas Jean**
**24, rue Sainte Hélène**
**F-69002 Lyon (FR)**

**Tournier, Robert**
**L'Archat**
**F-38850 Bilieu (FR)**

(74) Mandataire: **Dubruc, Philippe et al**
**RHONE-POULENC CHIMIE Service Brevets Chimie 25,**
**quai Paul-Doumer**
**F-92408 Courbevoie Cédex (FR)**

(54) Compositions de matière précurseurs de céramiques supraconductrices, leur préparation et leurs utilisations.

(57) Les compositions de matière précurseurs de matériaux céramiques supraconducteurs, sont dans un état finement divisé et substantiellement amorphe aux rayons X et elles contiennent, sous la forme d'un mélange homogène d'oxydes et/ou d'hydroxydes, tous les éléments chimiques requis pour l'obtention de la composition supraconductrice désirée.

La demande concerne egalement un procédé de préparation de ces compositions de matière.

EP 0 360 662 A1

Description

## COMPOSITIONS DE MATIERE PRECURSEURS DE CERAMIQUES SUPRACONDUCTRICES, LEUR PREPARATION ET LEURS UTILISATIONS

La présente invention a trait au domaine des matériaux céramiques supraconducteurs.

Plus précisement, l'invention vise à fournir de nouvelles compositions de matière destinées à consiter des précurseurs privilégiés de matériaux céramiques supraconducteurs.

Elle concerne également l'un des procédés de préparation de ces compositions précurseurs.

Elle concerne enfin, à titre d'application, l'utilisation desdites compositions pour la préparation de matériaux céramiques supraconducteurs pouvant se présenter sous diverses formes, telles que poudres, monolithes poreux ou pièces massives et denses.

On sait que, jusqu'à un passé récent, l'état supraconducteur, qui se caractérise entre autre par la disparition de toute résistance électrique dans un corps porté à très basse température, n'apparaissait dans certains matériaux qu'en dessous d'une température seuil, dite "température critique", généralement proche du zéro absolu.

Un telle contrainte a constitué à l'évidence un frein sérieux au développement sur une grande échelle de toutes les applications pratiques potentielles pouvant découler de la supraconductivité.

Or, depuis peu, des recherches ont permis de mettre en évidence de nouveaux matériaux qui présentent des propriétés supraconductrices à plus hautes températures, c'est-à-dire des températures s'étalent de 70 à 90° K, voire plus.

Ces matériaux sont pour la plupart à base de terres rares, d'alcalino-terreux, de métaux de transition et d'oxygène. Plus spécifiquement, les sytèmes étudiés les plus prometteurs semblent être ceux à base d'yttrium et/ou lanthane et/ou d'erbium, de baryum et/ou de strontium et/ou de calcium, de cuivre, et/ou éventuellement d'autres métaux de transition et d'oxygène.

La formulation $Y Ba_2 Cu_3 O_{7-x}$ ($O \leqq x \leqq 0,5$) constitue à ce jour un exemple particulièrement remarquable au sein de ces systèmes.

Ils peuvent se présenter à l'état de poudres, ou bien encore à l'état de pièces denses, mais de formes simples, obtenues par frittage naturel desdites poudres ; au niveau de certaines applications pratiques, seule en effet l'utilisation des produits frittés supraconducteurs présente un intérêt réel.

Mais la synthèse de ces matériaux, sous une forme ou sous une autre, pose à l'heure actuelle de nombreux problèmes.

Plus spécifiquement, la méthode de synthèse généralement décrite dans la littérature pour aboutir à ces matériaux sous forme de poudre repose sur une réaction à l'état solide, à hautes températures (proches de 1000°C) entre des oxydes et/ou des sels contenant un anion volatil (par exemple carbonate) des éléments correspondants, ces derniers composés se présentant initialement sous forme de poudres cristallisées.

Toutefois, un tel procédé présente plusieurs inconvénients sérieux.

D'une part, il est d'un contrôle délicat (difficultés à obtenir mécaniquement un mélange homogène au niveau des poudres de départ, réactions de diffusion à la fois lentes et difficiles entre solides cristallisés, etc...) et il en résulte généralement la formation de phases intermédiaires parasites conduisant à des inhomogénéités au sein du matériau. Ces inhomogénéités, non supraconductrices, modifient la composition de la phase majoritaire et abaissent en conséquence la valeur du courant critique admissible ou peuvent même rendre la céramique elle-même non supraconductrice.

D'autre part, il nécessite la mise en oeuvre de températures de réactions relativement élevées, températures auxquelles des phases liquides (eutectiques) génantes peuvent se former.

En outre, les risques d'introduire des impuretés néfastes lors de l'étape de broyage ultérieure qu'il est généralement nécessaire de mettre en oeuvre après calcination, peuvent être génants.

Enfin, ce procédé conduit à des poudres dont les qualités peuvent se révéler insuffisantes pour certaines applications particulières (difficultés à la mise en forme et/ou au frittage, faibles courants critiques dans les pièces, etc...). Ce problème de qualité peut être notamment relié à la morphologie non contrôlée des poudres de départ.

L'invention a pour but de résoudre les problèmes ci-dessus en proposant notamment de nouvelles compositions de matière qui présentent, entre autres, l'avantage de :
- permettre la préparation de produits céramiques supraconducteurs ultrafins et parfaitement homogènes tant chimiquement que morphologiquement,
- permettre cette préparation à des températures relativement plus basses que celles des procédés de l'art antérieur, et sans mis en oeuvre d'étape de broyage
- permettre la préparation de monolithes plus ou moins poreux, à microstructure orientée, et supraconducteurs.

On a maintenant trouvé que ces buts, et d'autres, peuvent être atteints au moyen de la présente invention qui concerne en effet, à titre d'objet premier, des compositions de matière précurseurs de matériaux céramiques supraconducteurs, lesdites compositions étant caractérisées par le fait qu'elles sont dans un état finement divisé et substantiellement amorphe aux rayons X et qu'elles contiennent, sous la forme d'un mélange homogène d'oxydes et/ou d'hydroxydes, tous les éléments chimiques requis pour l'obtention de la composition supraconductrice désirée.

Un procédé de préparation de telles compositions de matière constitutif d'un second objet de la présente invention, consiste à préparer, dans un solvant organique, un mélange contenant, dans les rapports stoechiométriques et sous la forme d'acétates, tous les éléments chimiques requis pour l'obtention de la composition supraconductrices désirée, ledit mélange contenant en outre de l'eau, puis à éliminer, dans les conditions hypercritiques, le solvant organique dudit mélange.

La Demanderesse a pu constater que, de façon totalement inattendue et surprenante, les compositions de matière obtenues selon le procédé ci-dessus, de part leur grande finesse, leur caractère essentiellement amorphe et leur parfaite homogénéité, permettent d'aboutir, par traitement thermique, aux compositions supraconductrices désirées de manière beaucoup plus rapide, facile, efficace, fiable et reproductible que par les procédés de l'art antérieur qui reposent, comme déjà indiqué, sur l'utilisation de mélanges, obtenus mécaniquement, entre des poudres cristallisées.

Mais d'autres caractéristiques, aspects et avantages de l'invention apparaitront encore plus clairement à la lecture de la description qui va suivre, et de l'exemple concret, mais non limitatif, relatif à sa mise en oeuvre.

On notera d'ores et déjà que l'exposé qui suit de la présente invention n'est pas limité à l'obtention d'une composition céramique supraconductrice particulière ; il doit être au contraire considéré comme étant de portée générale, c'est à dire comme pouvant s'appliquer à la préparation de toute composition céramique supraconductrice devant notamment se présenter sous la forme d'une poudre ultrafine et homogène.

A titre d'exemple de compositions céramique supraconductrices susceptibles d'être obtenues selon la présente invention, on peut plus particulièrement citer celles à base de terres rares (on entend par terre rare d'une part tout élément du Tableau Périodique dont le numéro atomique est compris, inclusivement, entre 57 et 71, et d'autre part l'yttrium et le scandium qui, par convention, sont assimilés ici à une terre rare), d'alcalino-terreux, de métaux de transition et d'oxygène (céramiques de type oxydes).

Les terres rares plus particulièrement préférées pour la mise en oeuvre de l'invention sont l'yttrium, le lanthane et l'erbium.

D'autre part, les alcalino-terreux utilisables dans la présente invention sont principalement le calcium, le baryum et le strontium.

Enfin, concernant les métaux de transition, on opèrera de préférence avec la cuivre, mais tout autre élément de transition peut éventuellement convenir.

L'invention s'applique particulièrement bien à la fabrication des systèmes supraconducteurs du type Y-Ba-Cu-O ; ces systèmes ont été étudiés notamment dans un article paru dans le Journal of American Chemical Society, 1987, 109, 2528-2530.

Pour des raisons de clarté et de simplicité, il est tout d'abord décrit le procédé de préparation des compositions de matière selon l'invention.

La première étape du procédé selon l'invention passe donc par la préparation d'une solution organique à base d'acétates.

Comme déjà indiqué, cette solution initiale doit contenir, dans les rapports stoechiométriques, tous les éléments chimiques nécessaires à l'obtention de la composition supraconductrice désirée. Elle peut être obtenue soit en introduisant directement des acétates solides dans la phase solvante organique, soit en procédant à des mélanges de solutions organiques d'acétates préablement préparées.

La phase solvante organique doit être de préférence telle que les acétates des divers éléments chimiques requis à l'obtention de la phase supraconductrice désirée soient ou bien substantiellement solubles dans ledit solvant organique, ou bien susceptibles de mener à des solutions colloïdales homogènes et stables.

Pour augmenter la solubilité et/ou la stabilité de certaines acétates dans la solution organique initiale, il peut être éventuellement nécessaire d'ajouter des composés chimiques bien connus de l'homme de l'art dans ce domaine.

Les solvants organiques particulièrement préférés pour la mise en oeuvre du procédé selon l'invention sont les alcools, et notamment le méthanol, l'éthanol, le propanol et le butanol. Le méthanol convient particulièrement bien.

Selon une caractéristique importante du procédé selon l'invention, le mélange initiale doit contenir en outre une certaine quantité d'eau.

Cette eau est nécessaire pour permettre l'obtention d'une composition de matière à base d'oxydes et/ou d'hydroxydes lors de la seconde étape du procédé selon l'invention développée ci-après (phénomène d'hydrolyse). La quantité d'eau utilisée est de préférence telle qu'elle permette d'assurer une hydrolyse totale des cations présents dans le mélange.

Dans la pratique, de très faibles quantités d'eau suffisent, et il n'est généralement pas nécessaire d'utiliser plus de 1 % d'eau en poids par rapport à la masse totale du mélange initial.

Le mélange initial à base d'acétates étant ainsi obtenu, on procède alors à l'élimination de la phase solvante organique.

Selon une caractéristique essentielle du procédé selon l'invention, cette élimination se fait en se plaçant dans les conditions hypercritiques du solvant. Pour ce faire, on peut par exemple tout d'abord chauffer le mélange préparé précédement dans un autoclave en portant la température de ce dernier à une température supérieure ou égal à la température critique du solvant, puis laisser progressivement revenir à pression ambiante ledit autoclave.

A l'issue de cette opération, on récupère une composition de matière finement divisée dont la surface spécifique B.E.T., suivant la température du traitement en autoclave, peut varier de 5 m²/g à plusieurs centaines de m²/g, cette surface spécifique étant de préférence supérieure à 10 m²/g.

Elle est constituée d'un mélange parfaitement homogène d'oxydes et/ou d'hydroxydes des éléments chimique introduits dans le mélange initial, ce mélange présentant la propriété remarquable d'être substantiellement amorphe aux rayons X.

Comme déjà indiqué, les compositions de matière selon l'invention constituent des précurseurs privilégiés de matériaux céramiques supraconducteurs.

Elle peuvent être tout d'abord utilisées à la préparation de poudres céramiques supraconductrices à la fois très fines, c'est à dire présentant une granulométrie moyenne de l'ordre du micron, et très homogènes chimiquement, c'est à dire avec une absence quasi-totale ou totale de phases parasites non supraconductrices. Dans ce but, il suffit de porter les compositions précurseurs à une température comprise entre 800°C et une température n'excédant pas la température de fusion de la composition, cette température étant plus particulièrement comprise enttre 800° et 950°C, et ceci sous une atmosphère contenant de l'oxygène (air par exemple), une atmosphère d'oxygène pur étant préférée. On observe en outre que des durées de chauffage relativement courtes, puisque n'excédant pas une à deux heures, suffisant à obtenir la composition supraconductrice désirée sous une forme cristallisée et parfaitement homogène.

Les poudres supraconductrices ainsi obtenues peuvent alors avantageusement être utilisées à la préparation de corps supraconducteurs très denses et très homogènes par mise en oeuvre des procédés classiques de frittage.

Outre la préparation directe de poudres supraconductrices telle que définie précédement, les compositions de matière selon l'invention trouvent une autre application utile. De part leur caractère essentiellement amorphe, il est en effet possible de préparer des pièces céramiques plus ou moins poreuses, à microstructure orientée, et supraconductrices. La microstructure orientée de la pièce finale permet ainsi d'assurer une meilleure conduction du courant électrique. Dans ce but, les compositions de matière amorphes selon l'invention sont préalablement compactées sous forme de pièces (le degré de compaction influant sur le degré de porosité de la pièce finale) puis frittées dans des conditions classiques ; le frittage assure alors la cristallisation et la densification orientées de la pièce.

Un exemple concret illustrant les divers aspects de l'invention va maintenant être donné.

Exemple

Cet exemple illustre les divers aspects de l'invention dans le cadre particulier de la préparation d'un matériau céramique supraconducteur de formule $YBa_2Cu_3O_{7-x}$ ($O \leqq x \leqq O,5$).

1 - Préparation du mélange initial

7,53g d'acétate de cuivre (II) monohydraté sont introduits dans 60 g de méthanol contenant 9,82 g d'acétoacétate d'éthyle, puis on agite pendant 48 heures jusqu'à l'obtention d'une dispersion colloïdale.

Dans 50g de méthanol, on dissout 4,255g d'acétate d'yttrium tétrahydraté.

Enfin, dans 85g de méthanol contenant 1g d'eau, on introduit 6,43g d'acétate de baryum.

Les solutions ou dispersions ainsi préparées sont alors mélangées comme suit :
- la dispersion d'acétate de baryum est tout d'abord introduite dans la solution d'acétate d'yttrium ;
- puis on ajoute dans ce mélange la dispersion d'acétate de cuivre, le nouveau mélange obtenu étant agité pendant 48 heures.

On obtient ainsi une solution homogène de méthanol contenant, dans les rapports stoechiométriques, et sous la forme d'acétates, tous les éléments chimiques requis pour l'obtention de la phase $YBa_2Cu_3O_{7-x}$.

2 - Préparation du précurseur

Le mélange préparé précédemment est introduit dans un autoclave en présence d'un excès de méthanol. L'autoclave est alors porté à une température de 270-280°C (donc au-dessus de la température critique du méthanol). A cette température, la pression dans l'autoclave s'établit à 80 - 100 bars (donc au-dessus de la pression critique du méthanol). Puis on laisse revenir progressivement (en 1 heure environ) l'autoclave à pression atmosphérique. Puis, pendant 15 mn, on fait passer un courant d'azote sec à travers l'autoclave maintenu à 270-280°C pour éliminer les dernières traces de méthanol. La température est ensuite ramenée à l'ambiante en 2 heures environ, puis on ouvre l'autoclave et on récupère la composition précurseur selon l'invention.

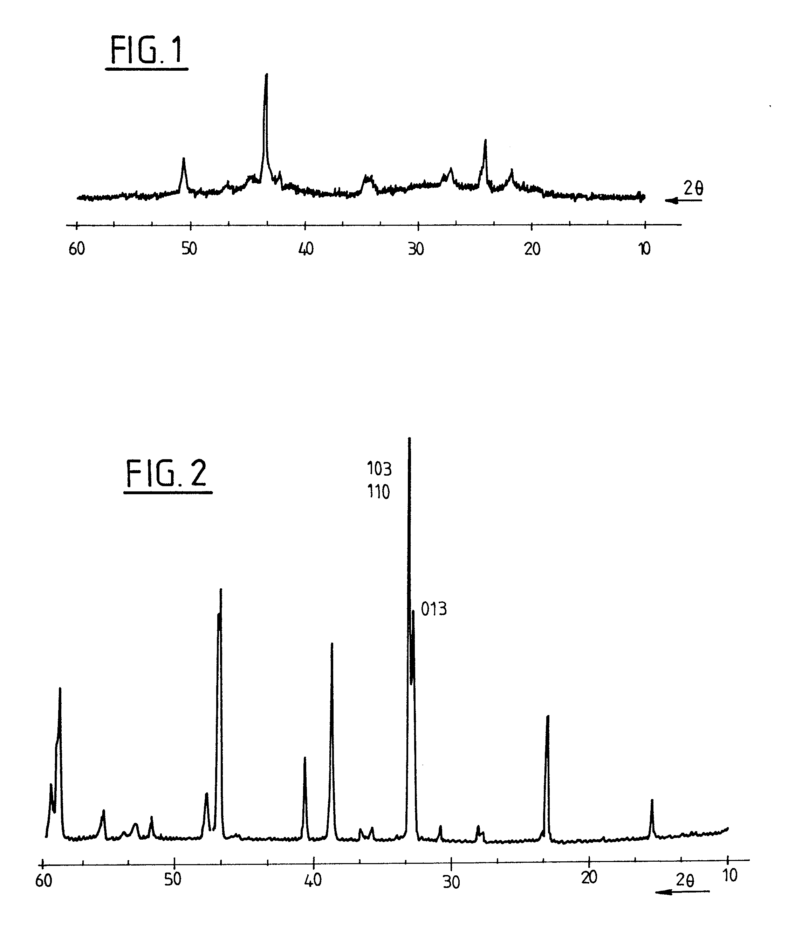

La composition se présente sous la forme d'une poudre homogène de faible densité, sa surface spécifique B.E.T. est de $52m^2/g$ et elle est amorphe aux rayons X. Le spectre X (Cu K$\alpha$) de cette poudre est donné à la figure 1 (les quelques pics du spectre sont dus à la présence d'une petite quantité résiduelle de cuivre métal).

3 - Préparation de la céramique supraconductrice

La composition amorphe obtenue précédemment est portée telle quelle (sans préchauffage ou broyage) à 950°C, sous oxygène pur, et maintenue à cette température pendant deux heures, puis ramenée à température ambiante, toujours sous oxygène pur, au rythme de 20°C/heure.

Durant cette opération, on observe que la composition commence à cristalliser vers 750°C ; de plus, même à 950°C, aucune phase liquide (eutectique) n'est observée.

L'analyse par diffraction X et l'analyse chimique de la poudre obtenue montre que cette dernière correspond au composé Y Ba$_2$ Cu$_3$ O$_{7-x}$ ($O \leqq x \leqq O,5$), cristallisé sous sa forme orthorombique ; aucune phase parasite n'est détectable (produit monophasique). La granulométrie moyenne de la poudre est de l'ordre du micron.

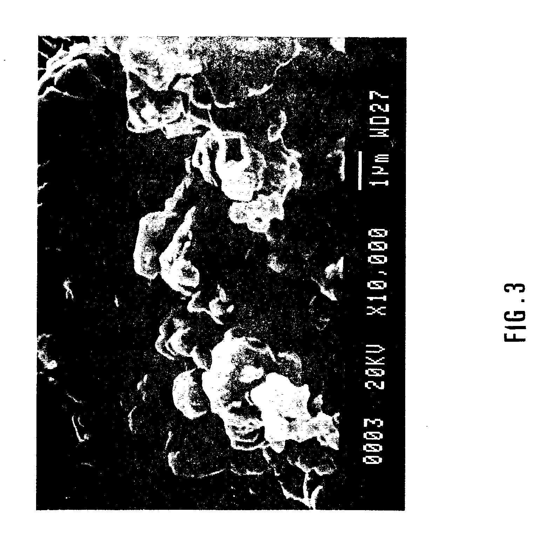

Le spectre X (Cu K$\alpha$) de cette poudre est donné à la figure 2, et une photographie de celle-ci est donnée à la figure 3.

Les mesures de caractérisations magnétiques montrent que ces poudres sont supraconductrices, qu'elles présentent un volume supraconducteur de 100 % et que leur Tc est de 92 K.

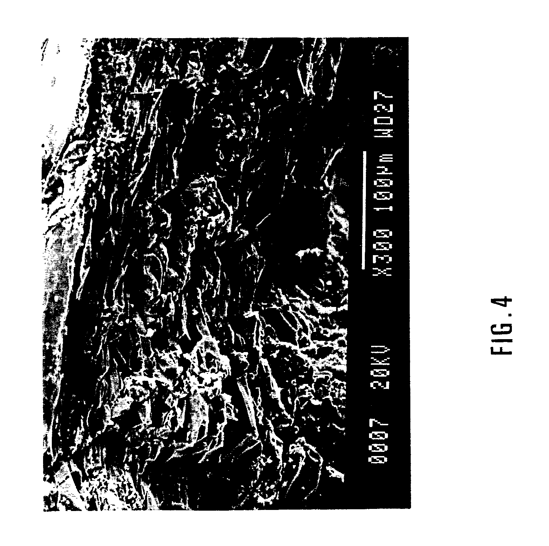

La figure 4 est une photographie d'un produit céramique obtenu après compaction puis traitement thermique (conditions identiques à celles décrites ci-avant : 2h à 950°C puis refroidissement 20°C/heure) du précurseur préparé précédemment ; elle montre clairement l'orientation préférentielle des grains selon les plans (a, b), la compaction ayant été effectuée selon l'axe c, et démontre la possibilité d'obtenir, par frittage, des pièces céramiques supraconductrices à microstructure orientée.

## Revendications

1 - Composition de matière précurseur d'un matériau céramique supraconducteur, caractérisée par le fait qu'elle est dans un état finement divisé et substantiellement amorphe aux rayons X et qu'elle contient, sous la forme d'un mélange homogène d'oxydes et/ou d'hydroxydes, tous les éléments chimiques requis pour l'obtention de la composition supraconductrice désirée.

2 - Compositions de matière selon la revendication 1 caractérisée en ce que sa surface spécifique B.E.T. est au moins de $10 \, m^2/g$.

3 - Composition de matière selon l'une quelconque des revendications 1 et 2 caractérisée en ce qu'elle constitue un précurseur d'un matériau céramique supraconducteur essentiellement à base d'au moins une terre rare, d'au moins un alcalino-terreux, d'au moins un métal de transition et d'oxygène.

4 - Composition de matière selon la revendication 3 caractérisée en ce que ladite terre rare est choisie parmi l'yttrium, le lanthane et l'erbium, ledit alcalino-terreux parmi le baryum et le strontium, et ledit métal de transition est le cuivre.

5 - Composition de matière selon la revendication 4 caractérisée en ce qu'elle est un précurseur d'un matériau céramique supraconducteur de formule $XBa_2Cu_3O_{7-x}$ dans laquelle X représente l'yttrium, le lanthane ou l'erbium, et x représente un nombre compris inclusivement entre 0 et 0,5.

6 - Procédé de préparation d'une composition de matière précurseur d'un matériau céramique supraconducteur, caractérisé par le fait qu'il consiste à préparer, dans un solvant organique, un mélange contenant, dans les rapports stoechiométriques et sous la forme d'acétates, tous les éléments chimiques requis pour l'obtention de la composition supraconductrice désirée, ledit mélange contenant en outre de l'eau, puis à éliminer, dans les conditions hypercritiques, le solvant organique dudit mélange.

7 - Procédé de préparation selon la revendication 6 caractérisé en ce que ledit solvant organique est un alcool.

8 - Procédé de préparation selon la revendication 7 caractérisé en ce que ledit alcool est choisi parmi le méthanol, l'éthanol, le propanol et le butanol.

9 - Procédé de préparation selon la revendication 8 caractérisé en ce que l'on utilise le méthanol.

10 - Procédé de préparation selon l'une quelconque des revendications 6 à 9 caractérisé en ce que l'on utilise une quantité d'eau telle qu'elle permette d'assurer une hydrolyse totale des cations présents dans le mélange.

11- Procédé de préparation selon l'une quelconque des revendications 6 à 10 caractérisé en ce que ladite élimination du solvant dans les conditions hypercritiques se fait dans un autoclave.

12 - Composition de matière obtenue par la mise en oeuvre d'un procédé tel que défini à l'une quelconque des revendications 6 à 11.

13 - Utilisation d'une composition de matière telle que définie à l'une quelconque des revendications 1 à 5 et 12 pour la préparation d'une poudre céramique supraconductrice.

14 - Utilisation d'une composition de matière telle que définie à l'une quelconque des revendications 1 à 15 et 12 pour le préparation d'une pièce céramique plus ou moins poreuse, à microstructure orientée, et supraconductrice.

FIG. 1

2θ

FIG. 2

103
110

013

2θ

FIG.3

EP 0 360 662 A1

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | JOURNAL OF THE AMERICAN CERAMIC SOCIETY, vol. 70, no. 12, decembre 1987, pages C-375-C-377, Westerville, OH, US; CHUNG-TSE CHU et al.: "Preparation of High-Tc superconducting oxides by the amorphous itrate process" * Pages C-375-C376; figure 1 * --- | 1 | C 04 B 35/00 H 01 L 39/12 H 01 L 39/24 |
| P,X | WO-A-8 809 701 (E.I. DU PONT DE NEMOURS & CO.) * Revendications 1,2; pages 12-16 * --- | 6 | |
| A | MATERIALS LETTERS, vol. 5, no. 10, septembre 1987, pages 387-390, Amsterdam, NL; N.K. KIM et al.: "Preparation, crystallization and properties of rapidly solidified YBa2Cu307-delta" * Page 388 * --- | 1 | |
| A | AMERICAN CERAMIC SOCIETY BULLETIN, vol. 67, no. 4, avril 1988, pages 759-762, Westerville, OH, USA; S.E. TROLIER et al.: "Dissolution of YBa2Cu30(7-x) in Various Solvents." * Page 761 * --- | 6 | DOMAINES TECHNIQUES RECHERCHES (Int. Cl.5) C 04 B 35/00 H 01 L 39/12 H 01 L 39/24 |
| P,A | GB-A-2 204 033 (GEC) * Revendication 1; page 4 * ----- | 6 | |

Le présent rapport a été établi pour toutes les revendications

| Lieu de la recherche | Date d'achèvement de la recherche | Examinateur |
|---|---|---|
| LA HAYE | 30-10-1989 | STROUD J.G. |